# EUROPEAN PATENT APPLICATION

(11) **EP 4 310 891 A1**
(43) Date of publication of application: **24.01.2024**
(21) Application number: 22185986.1
(22) Date of filing: 20.07.2022
(51) Int. Cl.: H01L 21/56, H01L 23/31, H01L 23/00

(54) **SEMICONDUCTOR DEVICE, BATTERY MANAGEMENT SYSTEM AND METHOD OF PRODUCING A SEMICONDUCTOR DEVICE**

(71) Applicant: Infineon Technologies Austria AG, 9500 Villach (AT)
(72) Inventor: EBNER, Sandra, 9523 Villach (AT); FRANK, Paul, 9500 Villach (AT); NAPETSCHNIG, Evelyn, 9103 Diex (AT); PAVIER, Mark, Felbridge, RH19 2PP (GB); RANACHER, Christian, 9905 Gaimberg (AT); VITANOV, Stanislav, 9500 Villach (AT)
(74) Representative: JENSEN & SON

(57) **Abstract**

In an embodiment, a semiconductor device 10 is provided that comprises a semiconductor die 11 comprising a front side 12, a rear side 13 opposing the front side 12 and side faces 14, a first transistor device 15 comprising a first source pad 16 and a first gate pad 17 on the front side 12, and a second transistor device 18 comprising a second source pad 19 and a second gate pad 20 on the front side. The first and second transistor devices 15, 18 each have a drain 20, 21 that is electrically coupled to a common drain pad 23 on the rear side 13 of the semiconductor die 11. The drain pad 23 has an upper surface 24 and side faces 25 and at least a central portion of the upper surface 24 is covered by a first electrically insulating layer 27.

## Description

### BACKGROUND

A semiconductor package may include one or more semiconductor devices in a housing. The package may include a substrate or a leadframe which includes outer contacts which are used to mount the electronic component on a redistribution board such as a printed circuit board. The package also includes internal electrical connections from the semiconductor device to the substrate or leadframe. The housing may include a plastic molding compound which covers the semiconductor device and the internal electrical connections.

In order to reduce the size of the semiconductor package, so called chip sized / chip-scale packages have been developed. Chip sized packages may be fabricated by manufacturing a semiconductor wafer which comprises a plurality of semiconductor devices at component positions in the wafer and a non-device region, also known as a saw street or kerf or singulation region. The non-device regions may surround each device region and delineate the component positions. Typically, the device regions are formed in a regular array of rows and columns so that the non-device regions have the form of an orthogonal grid. After forming the relevant components of the device, the wafer is separated into single chips or dies, for example by dicing the wafer, for example by sawing, through the thickness of the wafer along the non-device regions.

WO 2017/148873 A1 discloses a method in which a trench is formed in the first surface of the semiconductor wafer in the non-device regions between the component positions. A first polymer layer is applied to the first surface such that the trenches and edge regions of the component positions are covered with the first polymer layer and such that at least a portion of the first metallization structure is uncovered by the first polymer layer. Portions of the second opposing surface of the semiconductor wafer are removed to reveal portions of the first polymer layer in the non-device regions and the wafer is singulated by cutting through the first polymer layer in the non-device regions.

Further improvements to semiconductor devices and methods for fabricating semiconductor devices are desirable.

### SUMMARY

According to the invention, a semiconductor device is provided that comprises a semiconductor die comprising a front side, a rear side opposing the front side and side faces. The semiconductor die further comprises a first transistor device comprising a first source pad and a first gate pad on the front side and a second transistor device comprising a second source pad and a second gate pad on the front side. The first and second transistor devices each have a drain that is electrically coupled to a common drain pad on the rear side of the semiconductor die. The drain pad has an upper surface and side faces and at least a central portion of the upper surface is covered by a first electrically insulating layer.

Since the central portion of the drain pad is covered by the first electrically insulating layer, this central portion does not act as a contact surface for forming an external electrical connection to the drain regions of the first and second transistor devices. The drain pad is electrically floating. This semiconductor device is, therefore, suitable for use in applications in which access to the common drain of the two transistor devices is not required. An example of such an application is a battery protection switch.

The central portion is at least 80% and in some embodiments is at least 90% of the area of the upper surface of the drain pad. In some embodiments, the first electrically insulating layer is in direct contact with at least the central portion of the upper surface of the drain pad. In some embodiments, the first electrically insulating layer is an organic layer.

The semiconductor device comprises a single semiconductor die that includes two vertical transistor devices in which the drift zone extends substantially perpendicularly to the front die. The two transistor devices share a common drain pad. The drains of the first and second transistor devices are, therefore, electrically coupled together by way of the drain pad. The drain is typically formed by a doped region of the semiconductor die positioned under the drift zone. The first and second transistor devices are arranged laterally adjacent one another in the semiconductor die and can be switched independently of one another.

In some embodiments, the semiconductor die comprises an epitaxial silicon layer formed on a monocrystalline silicon substrate. In these embodiments, the source region, body region, gate and drift zone of each of the first and second transistor devices are formed in the epitaxial layer and the silicon substrate forms the drain.

In some embodiments, the drain regions are separated from one another by an insulation region and only electrically coupled by the drain pad. The insulation region may be a trench that is filled with electrically insulating material that extends through the thickness of the die or an implanted region.

In some embodiments, the drain regions of the first and second transistor devices are formed by a single doped region that is electrically connected to and in contact with the drain pad. In these embodiments, the electrical connection between the drains of the first and second transistor devices is made by both the common doped drain region and the common drain pad. Since the resistance of the drain pad is typically less than the resistance of the doped drain region, the drain pad provides the major portion of the electrical connection.

In some embodiments, the first and second transistor devices are electrically separated from one another by one or more trenches formed in the transistor structure at the front side that surround at least one of the transistor devices, in particular the active area including the active transistor cells of at least one of the transistor devices. The trench may be filled with electrically insulating material or by conductive material that is connected to drain potential.

In some embodiments, the side faces of the semiconductor die that extend between the front and rear surfaces are exposed and not covered by an electrically insulating layer, for example are not covered by the first electrically insulating layer on the rear surface. In some embodiments, a separate passivation layer may be arranged on the side faces if additional protection is desired.

In some embodiments, the upper surface and side faces of the drain pad are entirely covered by the first electrically insulating layer. In some embodiments, the portions of the rear surface of the semiconductor die that are not occupied by the drain pad are covered by the first electrically insulating layer.

In other embodiments, the side faces of the drain pad are uncovered and the central portion of the upper surface of the drain pad is covered by the first electrically insulating layer. In other words, 80% to 100% or 90% to 100% of the upper surface of the drain pad is covered by the first electrically insulating layer and the side faces and the portions of the rear surface of the semiconductor die that are not occupied by the drain pad are uncovered by the first electrically insulating layer.

In some embodiments, the central portion corresponds to the area of the upper surface of the drain pad so that the entire upper surface is covered by the first electrically insulating layer. In other embodiments, the central portion has an area that is less than the area of the upper surface so that a peripheral region of the upper surface that surrounds the covered central portion and that is situated between the covered central portion and the uncovered side face is uncovered by the first electrically insulating layer. The uncovered peripheral region extends between the edge formed between the upper surface and side faces of the drain pad and the first electrically insulating layer position on the upper surface of the drain pad. The uncovered peripheral region comprises less than 20% or less than 10% of the upper surface of the drain pad.

In some embodiments, the semiconductor device further comprises a first pad finishing layer that extends over the rear side of the semiconductor die and is arranged between the rear side of the semiconductor die and the first electrically insulating layer. The first pad finishing layer further extends over the drain pad such that the first pad finishing layer is arranged between the drain pad and the first electrically insulating layer.

The first pad finishing layer may provide adhesion promotion as it is arranged between the first electrically insulating layer and the drain pad and, optionally, also between the rear side of the semiconductor die and the first electrically insulating layer. The pad finishing layer may also be referred to as an intermediate layer.

In some embodiments, the lateral extent of the first pad finishing layer corresponds to the lateral extent of the first electrically insulating layer. The first pad finishing layer may extend over the entire drain pad and over the side faces and upper surface of the drain pad.

In some embodiments, the lateral extent of the first pad finishing layer is larger than the lateral extent of the first electrically insulating layer. For example, in embodiments in which the rear surface of the die and the side faces and, optionally, the peripheral regions of the upper surface of the drain pad are uncovered by the first electrically insulating layer, these regions are covered by the first pad finishing layer. The portion of the first pad finishing layer arranged on these regions is also exposed from the first electrically insulating layer.

In embodiments including a first pad finishing layer, the first insulating layer is separated from the rear side and the drain pad by the intervening pad finishing layer and is only in contact with the first pad finishing layer and not the drain pad or the rear side of the semiconductor die.

In some embodiments, the first and second source pads, the drain pad and the first and second gate pads comprise copper. In some embodiments, the first and second source pads, the drain pad and the first and second gate pads have a multilayer structure with one or more barrier layers arranged on the front surface or rear surface and the copper layer arranged on the barrier layer(s).

It is desirable to mark a semiconductor package with product information. This marking is typically arranged on the rear surface of the package in the mold compound so as to allow this information to be discernible after mounting of the package. For a chip scale package with an exposed copper pad on its rear side, if a product marking is formed in the upper surface of a copper pad, for example by engraving the drain pad in the present device as this remains unused for electrical connections, oxidation of the outer surface means that the marking becomes less discernible over time. The first electrically insulating layer that covers at least the central portion of the drain pad provides an outer surface which is more stable and which reduces the likelihood of oxidation. Additionally, the first electrically insulating layer can serve as a surface for product marking without the risk of the product marking becoming less discernible over time due to oxidation of the surface.

In some embodiments, the first electrically insulating layer is an organic layer and is formed of epoxy or polyimide. These materials are easily structurable or patternable using photolithographic techniques and compatible with common pad finishing layers so that, if a pad finishing layer is used, improved adhesion between the pad finishing layer and the epoxy or polyimide can be achieved. This further improves the reliability of the protection provided by the first electrically insulation layer.

In some embodiments, the first pad finishing layer comprises one or more of Ni, a NiV alloy, an oxide and a nitride. These materials provide good adhesion the first electrically insulating layer, in particular with epoxy resins and polyimide and with copper.

In contrast to the drain pad, which is electrically floating, the first and second source pads and the first and second gate pad on the opposing front side of the semiconductor die provide contact areas that are electrically accessible externally to the device. At least central portions, that is at least 80% or at least 90% of the outer surface of the first and second source pads and the first and second gate pads remain exposed to allow electrical connections to the respective pad to be formed, for example by solder in the case of surface mounting or by an additional connector such as a bond wire, metallic clip or metallic ribbon.

In some embodiments, the semiconductor device further comprises a second electrically insulating layer that covers the front side of the semiconductor die in regions that are not occupied by the first and second source pads and the first and second gate pads and that covers at least side faces of the first and second source pads and of the first and second gate pads. At least a central portion of each of the first and second source pads and each of the first and second gate pads is exposed from the second electrically insulating layer. This allows the central portion to act as an electrical contact area and provide a contact to this area of the pad which has a low resistance.

In some embodiments the semiconductor device further comprises a second pad finishing layer that is arranged between the front side of the semiconductor die and the second electrically insulating layer. In some embodiments, the second pad finishing layer extends between at least side faces of the first and second source pads and of the first and second gate pads on the front side of the die and between the front side of the die and the second electrically insulating layer.

The lateral extent of the second pad finishing layer may correspond to the lateral extent of the second electrically insulating layer. In these embodiments, the second electrically insulating layer is not in direct contact with the first and second source pads and the first and second gate pads or the front side of the semiconductor die, but is only in direct contact with the second electrically insulating layer.

In some embodiments, at least the central portion of the first and second source pads and of the first and second gate pads is exposed from the second pad finishing layer and from the second electrically insulating layer. At least central portions, that is at least 80% or at least 90% of the outer surface of the first and second source pads and the first and second gate pads, remain exposed to allow electrical connections to the respective pad to be formed.

In some embodiments, the second electrically insulating layer is formed of epoxy or polyimide. In some embodiments, the first and second source pads and the first and second gate pads are formed of copper. In some embodiments, the second pad finishing layer comprises one or more of Ni, a NiV alloy, an oxide and a nitride.

The same combination of materials may be used on the front side and the rear side of the semiconductor device.

In some embodiments, the side faces of the semiconductor die are uncovered by the first pad finishing layer, if present on the rear side, and are uncovered by the first electrically insulating layer. The side faces of the semiconductor die are also uncovered by the second pad finishing layer and second electrically insulating layer, if present, on the front side of the semiconductor die.

In some embodiments, the semiconductor device further comprises a product marking formed in an outer surface of the first electrically insulating layer.

The product marking may represent product tracking information and product identity information. Product tracking information may include the wafer fabrication lot number, the date on which the wafer was fabricated, the assembly lot number and the date on which the package was assembled. This information allows the manufacturer to track the manufacturing process and may be used to assist in solving manufacturing problems. Product identity information may include designations for the product type, package type and performance, for example speed or voltage. Other types of information about the package or semiconductor device within the package can be included in this information or be derivable from the information marked on the outer surface of the package.

Since semiconductor packages, in particular chip sized packages, have a limited area on which the information may be positioned, the information may be marked in the form of an alphanumeric code or barcode or data code matrix which is readable so as to convey more information about the package within a smaller space.

In some embodiments, the product marking comprises at least one alphanumeric character. An alphanumeric character describes one of the numbers 0 to 9 and the letters of the Latin alphabet. Punctuation marks such as full stops, commas, colons, back slashes, forward slashes etc are excluded from this definition.

In some embodiments, the product marking may be a two-dimensional matrix.

In some embodiments, the semiconductor die that is formed of monocrystalline silicon or comprises an epitaxial silicon layer that is optionally formed on a monocrystalline silicon base substrate.

In some embodiments, the first and the second transistor device is a MOSFET (Metal Oxide Semiconductor Field Effect Transistor) device, an insulated gate bipolar transistor (IGBT) device or a Bipolar Junction Transistor (BJT).

The electrodes or terminals of the transistor device are referred to herein as source, drain and gate. As used herein, these terms also encompass the functionally equivalent terminals of other types of transistor devices, such as an insulated gate bipolar transistor (IGBT). For example, as used herein, the term "source" encompasses not only a source of a MOSFET device and of a superjunction device but also an emitter of an insulator gate bipolar transistor (IGBT) device and an emitter of a Bipolar Junction Transistor (BJT) device, the term "drain" encompasses not only a drain of a MOSFET device or of a superjunction device but also a collector of an insulator gate bipolar transistor (IGBT) device and a collector of a BJT device, and the term "gate" encompasses not only a gate of a MOSFET device or of a superjunction device but also a gate of an insulator gate bipolar transistor (IGBT) device and a base of a BJT device.

Each of the first and second transistor devices typically includes a plurality of transistor cells electrically connected in parallel, each transistor cell having a transistor structure having a doped drain region, a doped drift region, a doped body region and doped source region and also a gate electrode which comprises polysilicon or metal. The semiconductor die may have the first conductivity type and form the drift region.

In some embodiments, a drain region of the first conductivity is type is formed at the rear side, the drift region of the first conductivity is arranged on the drain region, a body region of the second conductivity type is arranged on the drift region and a source region of the first conductivity type is arranged on or in the body region. The source region and the drain region are more highly doped than the drift region. The source region may be arranged at or near the front surface. The first gate of the first transistor device and the second gate of the second transistor device may be formed on the front surface of the wafer to form a planar gate or in a trench that extends from the first surface of the wafer into the volume of the wafer.

In an embodiment, a battery management system is provided that comprises a battery protection circuit and a battery protection switch. The battery protection switch is provided by the semiconductor device of any one of the embodiments described herein.

According to the invention a method of producing a semiconductor device is provided. The method comprises providing a semiconductor wafer comprising a plurality of component positions separated from one another by singulation regions located at least one of adjacent to and between the component positions. Each component position comprises a front side and a rear side opposing the front side, a first transistor device comprising a first source pad and a first gate pad on the front side and a second transistor device comprising a second source pad and a second gate pad on the front side. A drain pad is formed on the rear side of the component positions that is electrically coupled to a drain of the first transistor device and a drain of the second transistor device. The method further comprises covering at least a central portion of an upper surface of the drain pad by a first electrically insulating layer. The wafer is then singulated along the singulation regions to produce a plurality of semiconductor devices.

During singulation at least the central portion of the upper surface of the drain pad is covered by the first electrically insulating layer so that in the final semiconductor device, at least the central portion of the upper surface of the drain pad is covered by the first electrically insulating layer. The central portion is at least 80% or at least 90% of the upper surface of the drain pad.

The wafer may be singulated by laser dicing or mechanical sawing, for example, to separate the plurality of devices from the wafer.

The drain of the first and second transistor device formed in the component position may be formed by a doped region of the semiconductor wafer that is situated at or near the rear surface or that forms the rear surface of the wafer.

Each of the first and second transistor devices typically includes a plurality of transistor cells electrically connected in parallel, each transistor cell having a transistor structure having a doped drain region, a doped drift region, a doped body region and doped source region and also a gate electrode which comprises polysilicon or metal. The semiconductor die may have the first conductivity type and form the drift region. A drain region of the first conductivity is type is formed at the rear side, a drift region of the first conductivity is arranged on the drain region, a body region of the second conductivity type is arranged on the drift region and a source region of the first conductivity type is arranged on or in the body region. The source region and the drain region are more highly doped than the drift region. The source region may be arranged at or near the front surface. The first gate of the first transistor device and the second gate of the second transistor device may be formed on the front surface of the wafer and be planar gates or in a trench that extends from the first surface of the wafer into the volume of the wafer to from a trench gate.

In some embodiments, the method further comprises, before applying the first electrically insulating layer, forming a first pad finishing layer on the rear side of the wafer that covers side faces and the upper surface of the drain pad. Then the portion of the first pad finishing layer that is formed on at least the central portion of the upper surface of the drain pad is covered with the first electrically insulating layer. In other words, the first electrically insulating layer is formed directly on the pad finishing layer that is positioned directly on at least the central portion of the upper surface of the drain pad.

In some embodiments, the first pad finishing layer is deposited on the entire rear side of the semiconductor wafer including the upper surface and side faces of the drain pad and the regions of the rear surface of the semiconductor wafer that are not occupied by the drain pad.

In some embodiments, the first electrically insulating layer entirely overs the drain pad and the rear surface of the semiconductor wafer.

In some embodiments, the first electrically insulating layer is selectively applied to the central portion of the upper surface of the drain pad and the side faces of the drain pad and the rear surface of the semiconductor wafer remain exposed from the first electrically insulating layer.

In some embodiments, the first electrically insulating layer initially entirely covers the drain pad and the rear surface of the semiconductor wafer and then is removed from side faces of the drain pad and the rear surface of the semiconductor wafer leaving at least the central portion of the drain pad covered.

In some embodiments, the method further comprises forming a second pad finishing layer on the front side of the wafer that covers at least the side faces of the first and source pads and at least the side faces of the first and second gate pads. Then the second pad finishing layer is covered with a second electrically insulating layer. At least a central portion of the first and second source pads and of the first and second gate pads is exposed from the second pad finishing layer and from the second electrically insulating layer. The central portion is at least 80% or at least 90% of the upper surface of the respective pad. The second pad insulating layer may be used to improve the adhesion between the second electrically insulating layer and the front surface of the semiconductor die and the side faces of the pads on the front surface and improve the protection provided by the second insulating layer.

The second pad finishing layer may be formed selectively so as to leave the central portion of the first and second source pads and of the first and second gate pads is exposed from the second pad finishing layer. In other embodiments, the second pad finishing layer is deposited so that it covers the front surface of the wafer entirely including the central portion of the first and second source pads and of the first and second gate pads. Portions of the second pad finishing layer are them removed so that least at least the central portion of the first and second source pads and of the first and second gate pads is exposed from the second pad finishing layer.

The second pad finishing layer may serve as an adhesion promotion layer between the second electrically insulating layer and the material of the source pads and gate pads and the front surface of the die that is unoccupied by the source pads and gate pads.

The stack of a pad finishing layer and an electrically insulating layer provides improved passivation or protection for the surface on which it is positioned. The stack of a pad finishing layer and an electrically insulating layer having any one of the arrangements described herein is not limited to use in a chip scale package having two transistors with a common drain and may also be used for semiconductor devices that include a single semiconductor device in a semiconductor die to provide a chip scale package.

According to an embodiment of the invention, a semiconductor device is provided that comprises a semiconductor die that comprises a front side, a rear side opposing the front side and side faces and at least one pad on the front side and at least one pad on the rear side. The at least one pad on the front side and the at least one pad on the rear side are at least partially covered by a pad finishing layer and are at least partially covered by an electrically insulating layer arranged on the pad finishing layer.

According to an embodiment of the invention, a semiconductor device is provided that comprises a semiconductor die that comprises a front side, a rear side opposing the front side and side faces and at least one pad on the front side or on the rear side. The at least one pad on the front side or the at least one pad on the rear side is at least partially covered by a pad finishing layer and is at least partially covered by an electrically insulating layer arranged on the pad finishing layer.

In some embodiments, at least 80% or at least 90% of the upper surface of the pad on the rear side and/or front side is uncovered by the pad finishing layer and the electrically insulating layer. The lateral extent of the pad finishing layer and the electrically insulating layer may be substantially the same.

In some embodiments, the side faces of the semiconductor die are uncovered by the pad finishing layer and the electrically insulating layer.

In embodiments in which at least one pad is arranged on the front side and at last one pad is arranged on the rear side, the semiconductor die may comprise a vertical device, for example a vertical diode or a vertical transistor device.

In embodiments in which the pad(s) are arranged on one side of the die, typically the front side, the semiconductor die may comprise a lateral device, for example a lateral diode or a lateral transistor device.

In some embodiments, the electrically insulating layer is formed of epoxy or polyimide, and/or the first pad finishing layer comprises one or more of Ni, a NiV alloy, an oxide and a nitride, and/or the second pad finishing layer comprises one or more of Ni, a NiV alloy, an oxide and a nitride and/or the pads are formed of copper.

In some embodiments, the transistor device is a MOSFET (Metal Oxide Semiconductor Field Effect Transistor) device, an insulated gate bipolar transistor (IGBT) device or a Bipolar Junction Transistor (BJT).

The electrodes or terminals of the transistor device are referred to herein as source, drain and gate. As used herein, these terms also encompass the functionally equivalent terminals of other types of transistor devices, such as an insulated gate bipolar transistor (IGBT). For example, as used herein, the term "source" encompasses not only a source of a MOSFET device and of a superjunction device but also an emitter of an insulator gate bipolar transistor (IGBT) device and an emitter of a Bipolar Junction Transistor (BJT) device, the term "drain" encompasses not only a drain of a MOSFET device or of a superjunction device but also a collector of an insulator gate bipolar transistor (IGBT) device and a collector of a BJT device, and the term "gate" encompasses not only a gate of a MOSFET device or of a superjunction device but also a gate of an insulator gate bipolar transistor (IGBT) device and a base of a BJT device.

In some embodiments, the semiconductor die is formed of monocrystalline silicon or an epitaxial silicon layer that is optionally formed on a monocrystalline silicon base wafer.

The transistor device typically includes a plurality of transistor cells electrically connected in parallel, each transistor cell having a transistor structure having a doped drain region, a doped drift region, a doped body region and doped source region and also a gate electrode which comprises polysilicon or metal. The semiconductor die may have the first conductivity type.

For a vertical transistor device, a drain region of the first conductivity is type is formed at the rear side, a drift region of the first conductivity is arranged on the drain region, a body region of the second conductivity type is arranged on the drift region and a source region of the first conductivity type is arranged on or in the body region. The source region and the drain region are more highly doped than the drift region. The source region may be arranged at or near the front surface. The gate of the transistor device may be formed on the front surface of the wafer to form a planar gate or in a trench that extends from the first surface of the wafer into the volume of the wafer to form a gate trench transistor.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a cross-sectional view of a semiconductor device according to an embodiment.
Figure 2, which includes figures 2A and 2B, illustrates a simplified schematic diagram of a battery management system which comprises a battery protection circuit and a battery protection switch.
Figure 3, which includes figures 3A to 3D, illustrates various embodiments of a semiconductor device including two transistor devices electrically connected in a common drain configuration.
Figure 4, which includes figures 4A to 4C, illustrates a method for fabricating a semiconductor device according to an embodiment.
Figure 5A illustrates a semiconductor device which includes a single vertical transistor device according to an embodiment.
Figure 5B illustrates a semiconductor device which includes a single lateral transistor device according to an embodiment.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The figures illustrate relative doping concentrations by indicating "-" or "+" next to the doping type "n" or "p". For example, "n⁻" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

According to some embodiments, a battery protection switch (BPS) is provided that is a bi-directional switch with a low-ohmic common drain, which is electrically floating. The common drain is facilitated via a thick backside metal, e.g. 20 µm Cu which may be deposited by electroplating techniques. The backside is exposed in the application for this kind of protection switches. Therefore, it is desirable to protect the backside metal (e.g. Cu) from oxidation or discoloration. Another challenge is the chip marking as there is no mold compound for such a device when it is provided as a chip-scale package/wafer-level-package. Consequently, chip marking, for example sales code, lot information, etc., on the backside of the chip would be desirable.

As the Cu backside metal is exposed, discolorations caused by oxidation of the Cu in air may be an issue for handling at the user, due to poorer chip detection, optical appearance for example. A high oxidation level of the exposed Cu backside metal can lead to electrical abnormalities.

According to embodiments described herein a combination of a pad finish (e.g. NiV, oxides, etc.) together with an organic layer is used on the rear side and covers the drain pad.

The pad finish acts as protection of the backside metal from discoloration and oxidation. Furthermore, the pad finish also acts as an adhesion layer for a subsequent organic layer. The pad finish layer is formed of a material that is selected to have a good adhesion and also to be processable on silicon or an optional seed layer (e.g. Ti), as the backside metal is removed in the kerf region to avoid issues during the dicing process.

For facilitating chip marking, an organic layer such as epoxy is beneficial due to its similarity to widely used mold-compounds, for which the marking process is well established. The organic layer enables laser marking, while ensuring that the metal protection provided by the underlying pad finishing layer stays intact. Organic layers such as epoxy or imide have similar physical properties as mold-compounds, which are widely used for chip-encapsulation and also for the product marking and may be used as the organic layer which covers the drain pad. Consequently, a common-drain Cu backside device can be provided in the form of a chip-scale package, e.g. a battery protection switch in a chip-scale package.

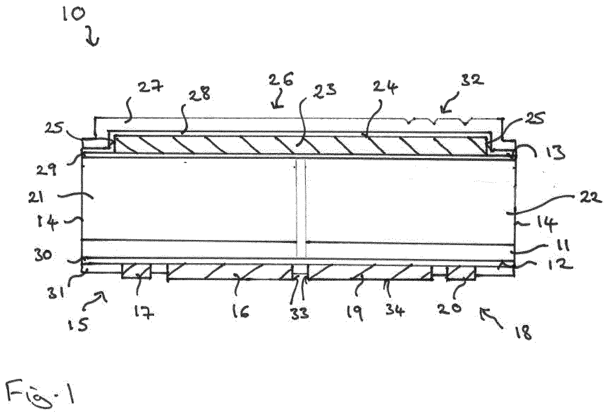

Figure 1 illustrates a cross-sectional view of a semiconductor device 10 according to an embodiment. The semiconductor device 10 comprises a semiconductor die 11 comprising a front side 12 and a rear side 13 which opposes the front side 12 and side faces 14 which extend between the front side 12 and the rear side 13. The semiconductor die 11 comprises a first transistor device 15 which comprises a first source pad 16 and a first gate pad 17 arranged on the front side 12 of the semiconductor die 11. The semiconductor die 11 further comprises a second transistor device 18 which comprises a second source pad 19 and a second gate pad 20 which are arranged on the front side 12. The second transistor device 18 is arranged laterally adjacent to the first transistor device 15 in the semiconductor die 11.

The first transistor device 15 further includes a first drain 21 and the second transistor device 18 further comprises a second drain 22. The first and second drains 21, 22 may be formed by a highly doped region of the semiconductor die 11 which is situated at or near the recent rear surface 13 the semiconductor die 11. The first and second drains 21, 22 of the first and second transistor devices 15, 18 are electrically coupled to a common drain pad 23 which is arranged on the rear side 13 of the semiconductor die 11.

The first transistor device 15 and the second transistor device 18 have a vertical drift path that extends substantially perpendicularly to the front side 12 and may be referred to as a vertical transistor device. In some embodiments, the first and second transistor devices 15, 18 are a MOSFET (Metal Oxide Semiconductor Field Effect Transistor) device, an insulated gate bipolar transistor (IGBT) device or a Bipolar Junction Transistor (BJT).

The electrodes or terminals of the transistor device are referred to herein as source, drain and gate. As used herein, these terms also encompass the functionally equivalent terminals of other types of transistor devices, such as an insulated gate bipolar transistor (IGBT). For example, as used herein, the term "source" encompasses not only a source of a MOSFET device and of a superjunction device but also an emitter of an insulator gate bipolar transistor (IGBT) device and an emitter of a Bipolar Junction Transistor (BJT) device, the term "drain" encompasses not only a drain of a MOSFET device or of a superjunction device but also a collector of an insulator gate bipolar transistor (IGBT) device and a collector of a BJT device, and the term "gate" encompasses not only a gate of a MOSFET device or of a superjunction device but also a gate of an insulator gate bipolar transistor (IGBT) device and a base of a BJT device.

The semiconductor die 11 may be formed of silicon, for example a single crystal silicon or comprise an epitaxial layer of silicon.

The drain pad 23 has an upper surface 24, which is substantially parallel to the rear side 13 of the semiconductor die 11, and side faces 25 which extend from the upper surface 24 to the rear side 13. In some embodiments, the drain pad 23 does not extend to the side faces 14 of the semiconductor die 11 but has an area which is slightly less than the area of the rear side 13 of the semiconductor die 11.

At least a central portion 26 of the upper surface 24 of the drain pad 23 is covered by a first electrically insulating layer 27, for example at least 80% or 90% of the upper surface 24 including the central portion is covered by the first electrically insulating layer 27. In some embodiments, the peripheral region or rim of the upper surface 24 is uncovered by the first electrically insulating layer 27. In some embodiments, such as that illustrated in figure 1, the entire upper surface 24 is covered by the first electrically insulating layer 27 and the side faces 25 of the drain pad 23 remain uncovered by the first insulating layer 27. In some embodiments, the entire upper surface 24, the entire side faces 25 of the drain pad 23 and the regions of the rear side 13 that are not covered by the drain pad 23 are covered by the first insulating layer 27.

The first insulating layer 27 prevents an electrical contact from being made to the drain pad 23 by a direct contact between an electrical connector, such as a bond wire or a contact clip or a solder connection and the upper surface 24 of the drain pad 23. Therefore, the drain pad 23 does not form an outer contact of the semiconductor device 10 but does provide an electrical connection between the drains 21, 22 of the first and second transistor devices 15, 28 that is electrically floating. The first insulating layer provides protection of the drain pad 23 from the atmosphere and can be used to prevent discoloration and oxidation of the outer surfaces of the drain pad 23.

In the embodiment illustrated in figure 1, the semiconductor device 10 further comprises a first pad finishing layer 28 that extends over the rear side 13 of the semiconductor die 11 and which is arranged between the rear side 13 of the semiconductor die 11 and the first insulating layer 27. The pad finishing layer 28 also extends over the drain pad 23 such that the first pad finishing layer 28 is arranged between the drain pad 23 and the first electrically insulating layer 27. Referring to figure 1, in some embodiments, the first pad finishing layer extends over the and is in direct contact with the upper surface 24 and the side faces 25 of the drain pad 23 and is in direct contact with the rear side 13 of the semiconductor die 11 in regions of the rear side 13 which are laterally adjacent the drain pad 23 and not occupied by the drain pad 23.

The drain pad 23 as well as the first and second source pads 16, 19 and the first and second gate pads 17, 20 which are arranged on the front side 12 may be formed of copper or a copper alloy. The composition of the pad finishing layer 28 may be selected depending on the composition of the drain pad 23 and the first insulating layer 27. In some embodiments, the pad finishing layer may comprise one or more of nickel, a nickel vanadium alloy, an oxide or a nitride and the first insulating layer 27 is formed of an organic material such as epoxy or polyimide.

In some embodiments, a seed layer 29 is arranged on the rear side 13 of the semiconductor die 11 and is in direct contact with the material of the rear side rear surface of the semiconductor die 11. The drain pad 23 is in direct contact with the seed layer 29. The seed layer 29 may be formed of a metal or alloy which is deposited by vacuum deposition techniques, for example by sputtering, onto the rear surface 13 and provides a conductive layer which acts as an electrode onto which the drain pad 23 can be deposited using galvanic or electroplating techniques. Galvanic and electroplating techniques have the advantage that a thicker drain pad 23 can be formed more quickly than in a vacuum deposition technique. The seed layer may be formed of Ti or Cu.

In some embodiments, a second seed layer 30 is also provided on the front side 12 of the semiconductor die 11 and the first source pad 16, the first gate pad 17, the second source pad 19 and the second gate pad 20 are arranged on the second seed layer 30. In some embodiments, a second electrically insulating layer 31 is arranged on the front side 12 and extends between the first source pad 16, first gate pad 17, the second source pad 19 and the second gate pad 20 and may extend between the side faces 33 of the first source pad 16, the first gate pad 17, the second source pad 19 and the second gate pad 20 as illustrated in figure 1. At least the central portion of each of the upper surface 34 of each of the first source pad 16, the first gate pad 17, the second source pad 19 and the second gate pad 20 remains exposed from and uncovered by the second electrically insulating layer 31.

The first source pad 16, the first gate pad 17, the second source pad 19 and the second gate pad 20 provide the outer contact surfaces of the semiconductor device 10 with which the device 10 is mounted onto a higher-level circuit board. A solder connection can be used between the first source pad 16, the first gate pad 17, the second source pad 19 and the second gate pad 20 and corresponding pads on the circuit board. The semiconductor device 10 is, therefore, a surface mount device.

The thickness of the second insulating layer 31 may be less than the thickness of the first source pad 16, the first gate pad 17, the second source pad 19 and the second gate pad 20 such that the pads protrude above the surface of the second insulating layer. In other embodiments, the second insulating layer 31 is arranged on the peripheral regions of the upper surface 34 of first source pad 16, first gate pad 17, the second source pad 19 and the second gate pad 20 leaving the central portion of the pad exposed and providing an outer contact area.

The side faces 14 of the semiconductor die 11 may be remain exposed and uncovered by the first and second insulating layers 27, 31 and first pad finishing layer 28 if present on the rear side 13 or may be covered by an additional thin passivation layer. The semiconductor device 10 can be considered to be a chip-sized or chip scale package.

A product marking 32 may be included on the outer surface of the first electrically insulating layer 27. The product marking may be formed by engraving and may comprise indentations and/or protrusions corresponding to one or more alpha numeric characters in order to convey information about the product.

The front side metallization typically has a multilayer structure with the pads 16, 17, 19, 20 being formed in the outermost conductive layer. Depending on the redistribution structure provided by the front side metallization, the arrangement of the pads may differ from the arrangement of the sources and gates of the two transistor devices 15, 18 that are formed in the semiconductor die 11. For example, in the semiconductor die 11, each of the first and second transistor devices 15, 18 includes a plurality of transistor cells in an active region, each transistor cell having a transistor structure with a gate and a source formed in the semiconductor die 11 at the front side 12. For the first transistor device 15, the gates are electrically connected by the front side metallization structure to the first gate pad 17 and the sources are electrically connected to the source pad 16. For the second transistor device 18, the sources are connected to the source pad 19 and the gates to the gate pad 20.

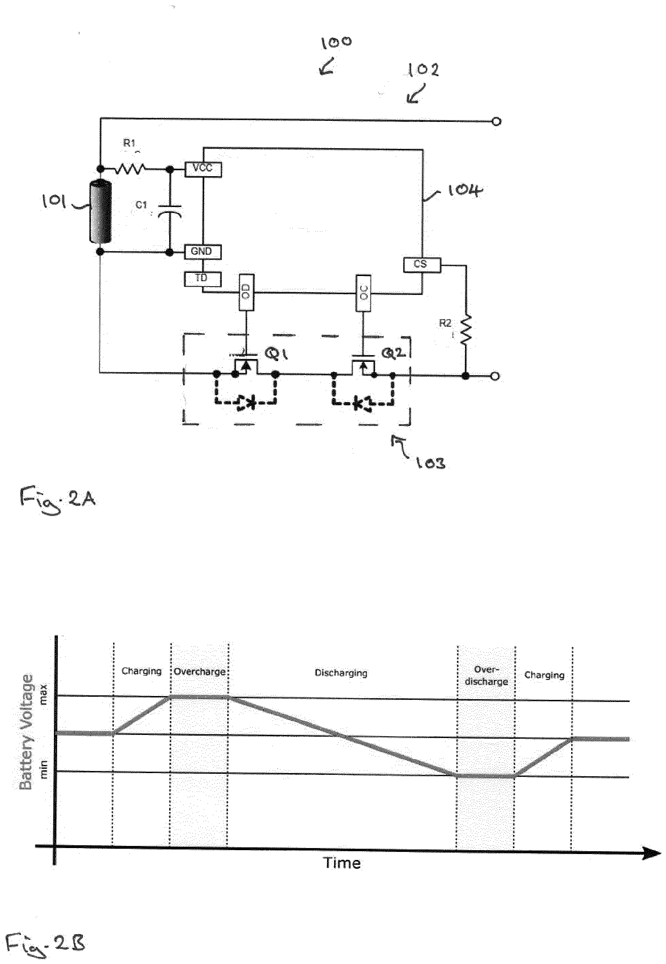

The semiconductor device 10 illustrated in figure 1 may be used in a battery management system. Figure 2, which includes figures 2A and 2B, illustrate a battery management system 100 for a battery 101 which comprises a battery protection circuit 102 and a battery protection switch 103 which comprises the semiconductor device 10 including two transistor devices having a common drain configuration according to any one of the embodiments described herein.

The battery management system (BMS) 100 is used to protect the battery 101, typically a Lithium-ion battery, against faulty operation and to optimize the charging and discharging processes in order to avoid failures like thermal runaway, lithium plating, electrode decomposition, etc. A battery management system 100 is used to increase lifetime and efficiency of lithium batteries, also under stressful conditions. The battery protection circuit 102 disconnects the battery 101 from the load when a critical condition is observed, such as short circuit, undercharge, overcharge or overheating. Additionally, the battery protection circuit 102 manages current rushing into and out of the battery, such as during pre-charge or hotswap turn on.

The battery management system 100 comprises a battery protection switch 103 which conducts current in two directions and comprises two transistor devices Q1, Q2 in a common drain configuration and a controller IC 104 protects rechargeable batteries 101 from operating outside of the safe operating area, for example protects the battery 101 from overcharge, over-discharge, overcurrent, etc. Depending on the operational mode, Q1 and Q2 can be turned on / turned off individually.

During charging of the battery 104, both Q1 and Q2 of the battery protection switch 103 are turned on, or only Q2 is turned on which leads to increased losses due to current flow through body-diode of Q1.

During discharging of the battery 104, both Q1 and Q2 of the battery protection switch 103 are turned on, or only Q1 is turned on which leads to increased losses due to current flow through body-diode of Q2.

Overcharge protection is provided when both Q1 and Q2 are turned off. Q1 still allows current flow through body-diode therefore Q2 is used to block the current flow. Overcharge protection is also provided when both Q1 and Q2 are turned off. Q1 still allows current flow through body-diode therefore Q2 is used to block the current flow. Over-discharge protection is provided when both Q1 and Q2 are turned off. Q2 still allows current flow through body-diode therefore Q1 is used to block the current flow.

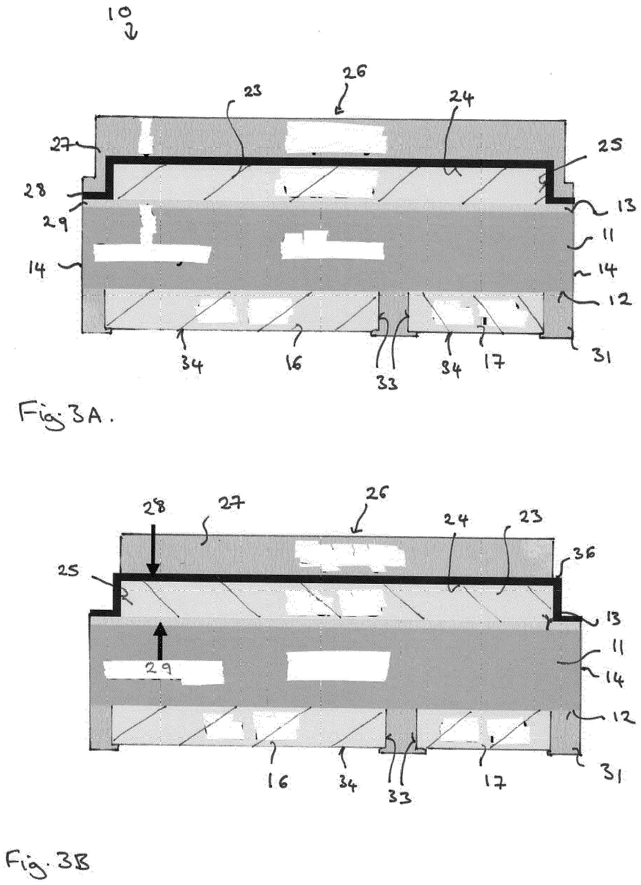

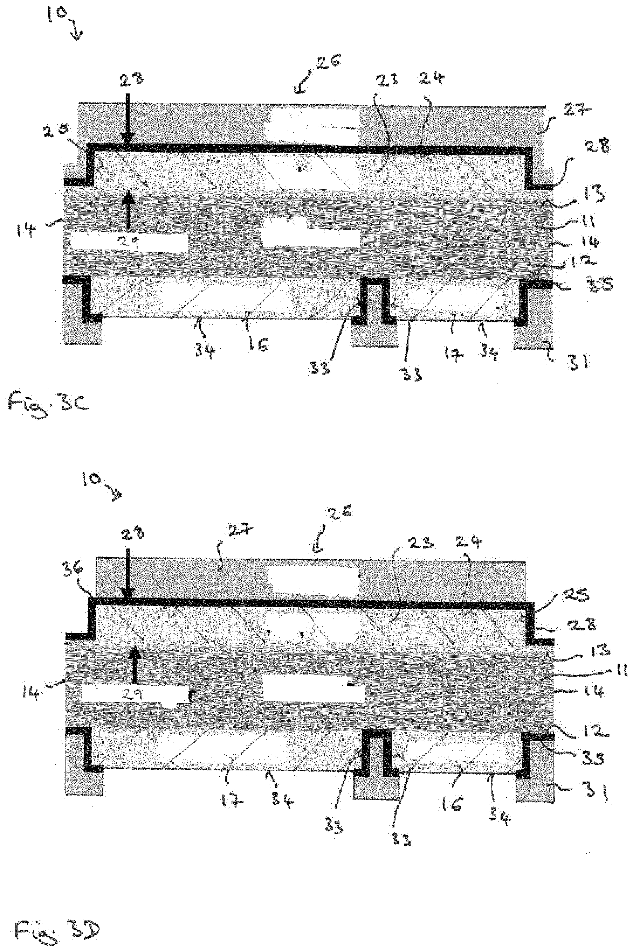

Figure 3, which includes figures 3A to 3D, illustrates various embodiments of the semiconductor device 10 including two transistor devices 15, 18 electrically connected in a common drain configuration, as illustrated in figure 1, whereby in the views of figure 3 only the first source pad 16 and the first gate pad 17 on the front side 12 the semiconductor die 11 can be seen.

Referring to figure 3A, in some embodiments, the arrangement of the second insulating layer 31 on the front side 12 of the semiconductor die 11 differs from that illustrated in figure 1 in that the second insulating layer 31 is in contact not only with the side faces 33 of the first source pad 16, the first gate pad 17, the second source pad 19 and the second gate pad 20 and the front side 12 of the semiconductor die 11 but also extends over the peripheral region of the outermost surface 34 of each of the first source pad 16, first the gate pad 17, the second source pad 19 and the second gate pad 20 as can be seen in figure 3A for the first source pad 16 and the first gate pad 17. The central portion of the outermost surface 34 of the first source pad 16, the first gate pad 17, the second source pad 19 and the second gate pad 20 remains uncovered by the second electrically insulating layer 31 and provide the outer contact surfaces of the device 10. The central portion is at least 80% or at least 90% of the outermost surface 34.

Figure 3B illustrates an embodiment which differs from that illustrated in figures 1 and 3A in that the first electrically insulating layer 27 which is arranged on the rear side 13 of the semiconductor die 11 is positioned only on the upper surface 24 of the drain pad 23 such that the side faces 25 of the die pad 23 are uncovered by the first electrically insulating layer 27. In this embodiment, the first pad finishing layer 28 is positioned on the side faces 25 and upper surface 24 of the die pad 23 as well as on the rear side 13 of the semiconductor die 11. Therefore, the portions of the first pad finishing layer 28 which are arranged on the side faces 25 and the rear side 13 of the semiconductor die 11 are exposed from the first electrically insulating layer 27.

A peripheral region 36 of the upper surface 24 of the die pad 23 that extends between the edge formed between the upper surface 24 and the side faces 25 and the side wall of the first electrically insulating layer 27 remains uncovered by the first electrically insulating layer 27. The peripheral region 36 is however covered by and in direct contact with the first pad finishing layer 29. The peripheral region 36 comprises less than 20% or less than 10% of the area of the upper surface 24.

Figure 3C illustrates an embodiment of the semiconductor device 10 which differs from that illustrated in figure 3A in that the semiconductor device 10 further comprises a second pad finishing layer 35 which is positioned on the front side 12 of the semiconductor die 11 and on side faces 33 and peripheral regions of the outermost surface 34 of the first source pad 16, the first gate pad 17, the second source pad 19 and the second gate pad 20 positioned on the front side 12 of the semiconductor die 11. The lateral extent of the second pad finishing layer 35 corresponds to that the lateral extent of the second electrically insulating layer 31 so that the second electrically insulating layer 31 is not in direct contact with either the front side 12 of the semiconductor die 11 or with the material of contact pads on the front side, as can be seen in the view of figure 3C for the first source pad 16 and the first gate pad 17. The central portion of the upper surface 34 of first source pad 16, the first gate pad 17, the second source pad 19 and the second gate pad 20, which is exposed from the second electrically insulating layer 31, is also exposed from the second pad finishing layer 35. In this embodiment, the first electrically insulating layer 27 covers the entire rear side 13 and is also not in direct contact with the rear side 13 of the semiconductor die 11 or with the drain pad 23 due to the intervening first pad finishing layer 28. In contrast to the arrangement on the front side 12, the first pad finishing layer 28 and the first electrically insulating layer 27 entirely covers the upper surface 24 and side faces 25 of the drain pad 23.

Figure 3D illustrates a semiconductor device 10 according to an embodiment which differs from that illustrated in figure 3C in that the first electrically insulating layer 27 is arranged only on the central portion of the outer surface 24 of the drain pad 23 so that the side faces 25 of the drain pad 23 and rear side 13 of the semiconductor die 11, which is not occupied and covered by the drain pad 23, are exposed from the first electrically insulating layer 28 as in the embodiment illustrated in figure 3B.

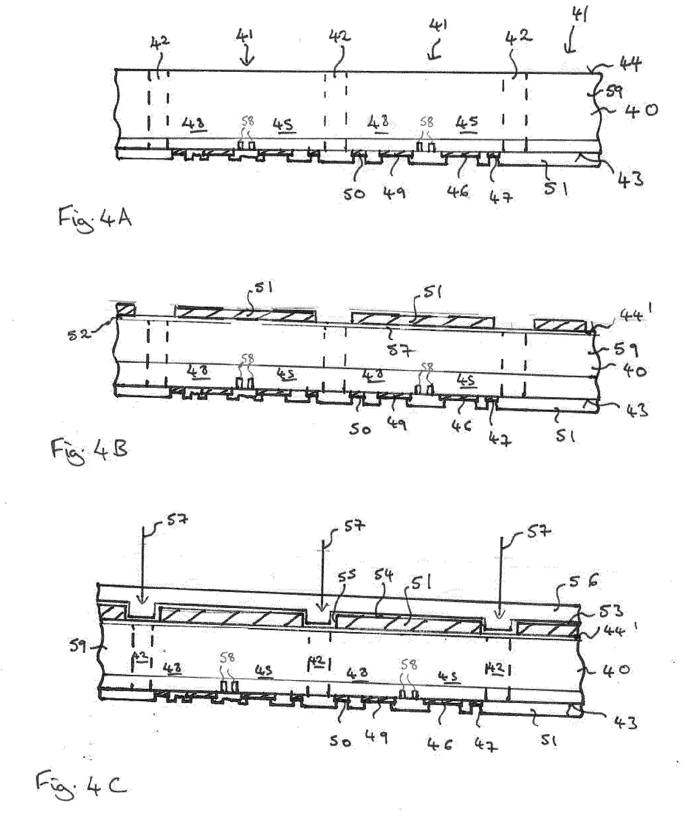

Figure 4, which includes figures 4A to 4C illustrates a method for fabricating a semiconductor device which may be used for fabricating the semiconductor device according to any one of the embodiments described herein. Typically, a plurality of semiconductor devices is fabricated using a semiconductor wafer at using the same processing steps.

Figure 4 illustrates a cross-sectional view of a portion of a semiconductor wafer 40 which includes a plurality of component positions 41 that are separated from one another by singulation regions 42. Typically, the component positions 41 are arranged in an array of rows and columns and the singulation regions 42 have the form of an orthogonal grid in plan view. One of the singulation regions 42 is located at least one of adjacent to and between the component positions 41. Each component position 41 provides a comprises a front side 43 and a rear side 44 which opposes the front side 43. The front side 43 of the individual component positions 41 and the rear side 44 of the individual component positions 41 is part of the front side 43 and rear side 44, respectively, of the semiconductor wafer 40. Each component position 41 further comprises a first transistor device 45 comprising a first source pad 46 and a first gate pad 47 on the front side 43 and a second transistor device 48 which comprises a second source pad 49 and a second gate pad 50 on the front side 43. The first and second transistor devices 45, 48 are arranged laterally adjacent one another in the component portion 41.

The front side 43 also comprises an electrically insulating layer 51 which is positioned on the front side 43 between the first and second source pads 46, 49 and the first and second gate pads 47,50. In some embodiments, the insulating layer 51 is in contact with only the side faces of the first and second source pads 46, 49 and with only the side faces of the first and second gate pads 47, 50. In some embodiments, the insulating layer 51 is arranged on the further arranged on the peripheral regions of the first and second source pads 46, 49 and the first and second gate pads 47, 50. In some embodiments, a pad finishing layer is arranged on the front surface 43 between the insulating layer 51 and the first and second source pads 46, 49 and first and second gate pads 47, 50 and has the form of an interfacial layer, as example illustrated in figures 3C and 3D. Processing of the front surface 43 and the metallisation structure thereon may be completed, before processing of the rear surface 44 is performed.

In some embodiments, the rear surface 44 of the wafer 40 is subjected to grinding to reduce the thickness of the semiconductor wafer 40 and expose the heavily doped drain region 59 that is common to both of the first and second transistor device 45, 48 in the worked rear surface 44' of the semiconductor wafer 40. Referring to figure 4B, a drain pad 51 is formed on the rear side 44 of the component positions 41 so that it is electrically coupled to drain region 59 of the first transistor device 45 and of the second transistor device 48 which is formed at the worked second rear surface 44'. In some embodiments, a seed layer 52 is first deposited on the worked rear surface 44', for example by sputtering or another vacuum deposition technique, and the drain pad 51 is deposited on the seed layer 52 using galvanic or electroplating techniques. The seed layer 52 is used as an electrode when depositing the drain pad 51 using galvanic or electroplating techniques.

Referring to figure 4C, a pad finishing layer 53 is then applied to the worked rear surface 44' which covers the upper surface 54 and side faces 55 of the drain pads 51 as well as the regions of the worked surface 44' which do not include a drain pad 51 such as in the singulation regions 42. An electrically insulating layer 56 is applied which covers the entire worked rear surface 44' and the pad finishing layer 55 so that the entire surfaces of the drain pads 51, i.e. the side faces 53 and upper surface 54, are covered by the insulating layer 56. The insulating layer may be an organic layer such as an epoxy resin or polyimide.

Referring to figure 4C, a singulation process is then carried out as indicated by the arrows 57 to singulate the wafer 40 along the singulation regions 42 and produce a plurality of separate semiconductor devices form the semiconductor wafer 40. In some embodiments, the pad finishing layer 53 may be omitted and the insulating layer 56 is in direct contact with the upper surface 54 and side faces 53 of the drain pads 51 and the seed layer 52 or in embodiments in which the seed layer 52 is omitted, is in direct contact with the worked surface 44'.

In some embodiments, after applying the insulating layer 56 such that it covers the entire worked rear surface 44' and the drain pads 51, portions of the first electrically insulating layer 56 are removed to expose the side faces 55 of the die pads 51 and the worked rear surface 44' of the semiconductor wafer 40, in regions which do not include a drain pad 51. The central portion of the upper surface 54 of the drain pad 51 is, however, covered by the electrically insulating layer 56. In some embodiments, only the side faces 55 remain uncovered by the insulating layer 56 or a minor portion of the peripheral region of the upper surface 54 and the side faces 55 may be uncovered by the insulating layer 56.

In some embodiments, the first and second transistor devices 45, 48 of each component position 41 may be electrically isolated from one another by an electrically insulating region.

In other embodiments, the isolation between the first and second transistor 45, 48 in each component position 41 may be formed by sections of the transistor structure formed in the front surface 43, for example, by trenches 58 similar to the field plate trenches of the transistor structure. These isolation structures 58 may be electrically connected to drain potential.

In some non-illustrated embodiments, the insulating region initially has the form of a trench which is inserted from the front surface 43 and which has a base positioned within the wafer 40. The trench is filled with insulating material. In embodiments in which the rear side 44 is subjected to grinding and the thickness of the wafer 40 is reduced, the insulating material within the trench may be exposed in the rear surface 44' and the seed layer 52 and the drain pad 51 extends over this insulating material.

The drain pad 51, the first and second source pads 46, 49 and the gate pads 47, 50 may comprise copper. The pad finishing layer, if used on one or both of the front and rear surfaces 43, 44, may comprise one or more of nickel, nickel vanadium alloy, an oxide and nitride. The insulating layers 51, 56 arranged on the front side 43 and rear side 44 may be formed of epoxy or polyimide.

The stack of a pad finishing layer and electrically insulating layer may also be used in semiconductor devices in which the semiconductor die includes a single device, for example a single transistor device or a single diode.

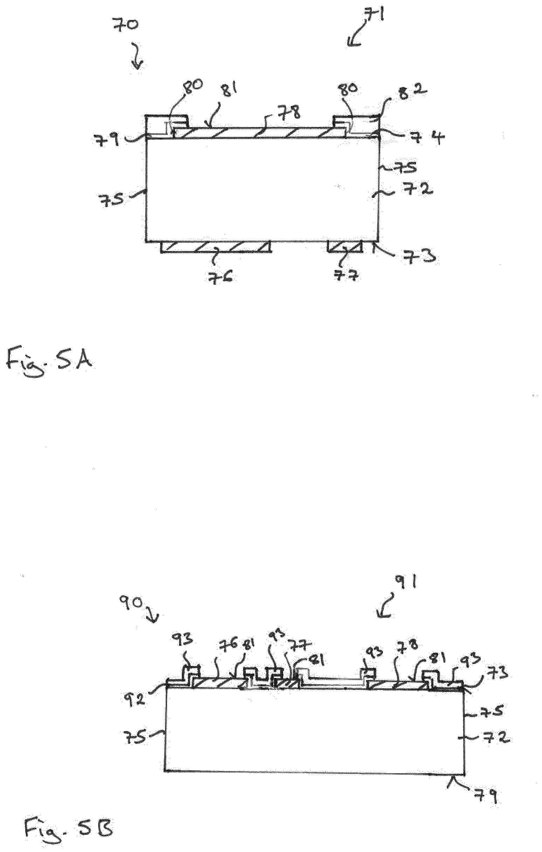

Figure 5A illustrates an embodiment of a semiconductor device 70 which includes a single transistor device 71 formed in a semiconductor die 72 having a front side 73, a rear side 74 opposing the front side 73 and side faces 75 which extend between the front side 73 and the rear side 74. The transistor device 71 further comprises a source pad 76 and gate pad 77 on the front side 73 and a drain pad 78 on the rear side 74. The transistor device 71 may have a vertical drift path that extends between the front side 73 and rear side 74 and be referred to as a vertical transistor device.

The semiconductor device 70 further comprises a pad finishing layer 79 which is arranged on the rear side 74 in regions laterally adjacent the drain pad 78 and which extends over side faces 80 and the peripheral region of the outermost surface 81 of the drain pad 78. An electrically insulating layer 82 is arranged on the rear side 74 which has a lateral extent which correspond substantially to the lateral extent of the pad finishing layer 79. Consequently, the electrically insulating layer 82 is not in direct contact with the rear side 74 of the semiconductor die 72 or with the drain pad 78 due to the intervening pad finishing layer 79.

In contrast to the embodiments illustrated in figures 1 to 3, at least the central portion of the outer surface 81 of the drain pad 78 on the rear side 74 the semiconductor die 72 is exposed and uncovered by the electrically insulating layer 82 and the pad finishing layer 78 arranged on the rear side 74 of the semiconductor die 72. The central portion is at least 80% or at least 90% of the area of the upper surface.

In this embodiment, the front side 73 is free of a pad finishing layer and an electrically insulating layer. However, the front side 73 may have an arrangement corresponding to the front side shown in figures any one of the embodiments described with reference to figures 1 and 3.

Figure 5B illustrates a semiconductor device 90 according to an embodiment which includes a single lateral transistor device 91 formed in the semiconductor die 72 in which the drift path extends parallel to the front side 73. The source pad 76, gate pad 77 and drain pad 78 are arranged on the front side 73. The gate pad 77 may be arranged laterally between the source pad 76 and the drain pad 78.

The semiconductor device 90 further comprises a pad finishing layer 92 which is arranged on the front side 73 in regions laterally adjacent the source pad 76, the gate pad 77 and drain pad 78. The pad finishing layer 92 also extends over the side faces 80 and the peripheral region of the outermost surface 81 of each of the source pad 76, the gate pad 77 and the drain pad 78. An electrically insulating layer 93 is arranged on the front side 73 which has a lateral arrangement which corresponds substantially to the lateral extent of the pad finishing layer 79. Consequently, the electrically insulating layer 93 is not in direct contact with the front side 73 of the semiconductor die 72 or with the side faces and peripheral regions of the source pad 76, the gate pad 77 and the drain pad 78 due to the intervening pad finishing layer 92. The central portion of the upper surface 81 and the majority of the upper surface 81 of the source pad 76, gate pad 77 and drain pad 78 remains uncovered by the pad finishing layer 92 and the electrically insulating layer 93.

The front side metallization typically has a multilayer structure with the pads 76, 77, 78 being formed in the outermost conductive layer. Depending on the redistribution structure provided by the front side metallization, the arrangement of the pads 76, 77, 78 may differ from the arrangement of the source, gate and drain formed in the semiconductor die 72. For example, in the semiconductor die 91, the transistor structure may include a plurality of transistor cells, each having a gate arranged laterally between a source and a drain. The gates are electrically connected by the front side metallization structure to the gate pad 77, which may be arranged in a corner of the front side or towards on edge of the front side 73 intermediate the width. The sources are electrically connected to the source pad 76 and the drains to the drain pad 78.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device (10), comprising:
a semiconductor die (11) comprising a front side (12), a rear side (13) opposing the front side (12) and side faces (14), a first transistor device (15) comprising a first source pad (16) and a first gate pad (17) on the front side (12), and a second transistor device (18) comprising a second source pad (19) and a second gate pad (20) on the front side (12),
wherein the first and second transistor devices (15, 18) each have a drain (20, 21) that is electrically coupled to a common drain pad (23) on the rear side (13) of the semiconductor die (11),
wherein the drain pad (23) has an upper surface (24) and side faces (25) and at least a central portion of the upper surface (24) is covered by a first electrically insulating layer (27).

2. A semiconductor device (10) according to claim 1, wherein the upper surface (24) and side faces (25) of the drain pad (23) are entirely covered by the first electrically insulating layer (27), or the side faces (25) of the drain pad (23) are uncovered and the central portion of the upper surface (24) of the drain pad (23) is covered by the first electrically insulating layer (27).

3. A semiconductor device (10) according to claim 1 or claim 2, further comprising a first pad finishing layer (28) that extends over the rear side (13) of the semiconductor die (11) and is arranged between the rear side (13) of the semiconductor die (11) and the first electrically insulating layer (27) and that extends over the drain pad (23) such that the first pad finishing layer (28) is arranged between the drain pad (23) and the first electrically insulating layer (27).

4. A semiconductor device (10) according to any one of claims 1 to 3, wherein
the first electrically insulating layer (27) is formed of epoxy or polyimide and/or
the first pad finishing layer (28) comprises one or more of Ni, a NiV alloy, an oxide and a nitride and/or
the first and second source pads (16, 19), the drain pad (23) and the first and second gate pads (17, 20) comprise copper.

5. A semiconductor device (10) according to any one of claims 1 to 4, further comprising a second electrically insulating layer (31), wherein the front side (12) of the semiconductor die (11) and at least side faces (33) of the first and second source pads (16, 19) and of the first and second gate pads (17, 20) are covered with the second electrically insulating layer (31) and at least a central portion of the first and second source pads (16, 19) and of the first and second gate pads (17, 20) is exposed from the second electrically insulating layer (31).

6. A semiconductor device (10) according to claim 5, further comprising a second pad finishing layer (35) arranged between the front side (12) of the semiconductor die (11) and the second electrically insulating layer (31) and between at least side faces (33) of the first and second source pads (16, 19) and of the first and second gate pads (17, 20) and the second electrically insulating layer (31), wherein at least the central portion of the first and second source pads (16, 19) and of the first and second gate pads (17, 20) is exposed from the second pad finishing layer (35) and from the second electrically insulating layer (31).

7. A semiconductor device (10) according to claim 6, wherein
the second electrically insulating layer (31) is formed of epoxy or polyimide and/or
the second pad finishing layer (35) comprises one or more of Ni, a NiV alloy, an oxide and a nitride.

8. A semiconductor device (10) according to any one of claims 1 to 7, further comprising a product marking (32) formed in an outer surface of the first electrically insulating layer (27).

9. A battery management system (100), comprising a battery protection circuit (102) and a battery protection switch (103), the battery protection switch (103) comprising the semiconductor device (10) of any one of claims 1 to 8.

10. A method of producing a semiconductor device, the method comprising:
providing a semiconductor wafer (40) comprising a plurality of component positions (41) separated from one another by singulation regions (42) located at least one of adjacent to and between the component positions (41), wherein each component position (41) comprises a front side (43) and a rear side (44) opposing the front side (43), a first transistor device (45) comprising a first source pad (46) and a first gate pad (47) on the front side (43) and a second transistor device (48) comprising a second source pad (49) and a second gate pad (50) on the front side (43),
forming a drain pad (51) on the rear side (44) of the component positions (41) that is electrically coupled to a drain of the first transistor device (45) and a drain of the second transistor device (48),
covering at least a central portion of an upper surface of the drain pad (51) by a first electrically insulating layer (56);
singulating the wafer (40) along the singulation regions (42) to produce a plurality of semiconductor devices.

11. A method according to claim 10, further comprising:
forming a first pad finishing layer (53) on the rear side (44) of the wafer (40) that covers side faces (55) and the upper surface (54) of the drain pad (51) and then covering the first pad finishing layer (53) formed on at least the central portion of the upper surface (54) of the drain pad (51) with the first electrically insulating layer (56).

12. A method according to claim 10 or claim 11, wherein the first electrically insulating layer (51) is selectively applied to the central portion of the upper surface (54) of the drain pad (51) and side faces (55) of the drain pad (51) and the rear surface (44) of the semiconductor wafer (40) are exposed from the first electrically insulating layer (56), , or the first electrically insulating layer (56) entirely overs the drain pad (51) and the rear surface (44) of the semiconductor wafer (40).

13. A method according to any one of claims 10 to 12, further comprising:
forming a second pad finishing layer on the front side of the wafer that covers at least the side faces of the first and source pads (46, 49) and of the first and second gate pads (47, 50) and then
covering the second pad finishing layer with a second electrically insulating layer (51),
wherein at least a central portion of the first and second source pads (46, 49) and of the first and second gate pads (47, 50) is exposed from the second pad finishing layer and from the second electrically insulating layer (51).

14. A semiconductor device (70; 90), comprising:
a semiconductor die (72) comprising a front side (73), a rear side (74) opposing the front side (73) and side faces (75), at least one pad (76, 77) on the front side (73) and/or at least one pad (78) on the rear side (74),
wherein the at least one pad (76, 77) on the front side (73) and/or the at least one pad (78) on the rear side (74) is at least partially covered by a pad finishing layer (79; 92) and by an electrically insulating layer (82; 93) arranged on the pad finishing layer (79; 92).

15. A semiconductor device (70; 90) according to claim 14, wherein
the electrically insulating layer (82; 93) is formed of epoxy or polyimide, and/or
the pad finishing layer (79, 92) comprises one or more of Ni, a NiV alloy, an oxide and a nitride, and/or
the pads (76, 77, 78) comprise copper.
